# EUROPEAN PATENT APPLICATION

(11) **EP 3 214 721 A1**
(43) Date of publication of application: **06.09.2017**
(21) Application number: 15854536.8
(22) Date of filing: 29.09.2015
(51) Int. Cl.: H02J 7/00, H01M 10/46, H01M 10/48, H01M 10/613, H01M 10/617, H01M 10/6235, H01M 10/637, H01M 10/643, H01M 10/6563

(54) **CHARGING DEVICE**

(30) Priority: 31.10.2014 JP 2014222587
(71) Applicant: Hitachi Koki Co., Ltd., Tokyo 108-6020 (JP)
(72) Inventor: NAMIKI, Masaki, Hitachinaka-City Ibaraki 312-8502 (JP)
(74) Representative: Parker, Andrew James
(86) International application number: PCT/JP2015/077479
(87) International publication number: WO 2016/067808

(57) **Abstract**

To reduce standby time during charging, a charging device includes a housing 3 on which a battery pack 2 is detachably mountable, a control board 5, and a cooling fan 6. The battery pack is formed with a vent hole 2a. The housing is formed with a ventilation opening 3a configured to face the vent hole. The cooling fan is configured to flow an air passing through the control board and the ventilation opening, and is configured to work even in a state where the battery pack is detached.

## Description

### [Technical Field]

The present invention relates to a charging device, and particularly to a charging device suitable for charging a battery pack used as the power supply for various apparatuses, tools, and the like (hereinafter called "power tools").

### [Background Art]

In recent years, a variety of battery packs housing lithium-ion batteries have been used to power cordless electrical equipment. Lithium-ion batteries are preferred for powering high-load equipment, such as power tools. These types of battery packs tend to generate a lot of heat when being charged. Therefore, a technique was proposed for efficiently cooling the battery pack by disposing a cooling fan in the charging device (see Patent Document 1).

### [Citation List]

### [Patent Literature]

Patent Document 1: Japanese Patent Application Publication No. 2014-117052

### [Summary of Invention]

### [Technical Problem]

The conventional technology described above can cool a battery pack efficiently based on the condition of the battery pack. However, since the circuit board, elements, and the like in the charging device also generate a lot of heat when charging the battery pack, the hot circuit board, components, and the like must be allowed to cool naturally after a charging operation. As a consequence, charging a plurality of battery packs one after another (hereinafter called "sequential charging") requires extra time between charges (hereinafter called "standby time") for cooling the internal components of the charging device, such as the circuit board and other elements.

In view of the foregoing, it is an object of the present invention to provide a technique for more efficiently cooling the internal components of a charging device.

### [Solution to Problem]

In order to give a solution to the above technical problem, the invention provides a charging device including a housing on which a battery pack is detachably mountable; and a cooling fan disposed in the housing and configured to generate cooling air in the housing even in a state where the battery pack is detached from the housing.

According to the above configuration, the components in the housing can be cooled even in the state where the battery pack is detached from the housing.

Preferably, the housing in the charging device accommodates therein a control board and is formed with a ventilation opening. The control board is configured to control charging of the battery pack. The ventilation opening is configured to face a vent hole formed in the battery pack when the battery pack is mounted on the housing. At least one of the battery pack and the control board is configured to be cooled by the cooling air generated by the cooling fan.

According to the above configuration, the charging device can cool at least one of the battery pack and the control board. Accordingly, the charging device can rapidly cool inside the housing and the control board as well as the battery pack. Further, since the charging device can cool the control board in the state where the battery pack in detached, the cooling of the control board after charging can be efficiently carried out. Specifically, when charging a plurality of battery packs one after another (sequential charging) and when charging a battery pack after charging another battery pack with large current, the extra time between charges (standby time) for cooling the internal components of the charging device can be reduced. Accordingly, the charging time of battery packs can be reduced, and the temperatures of the components in the charging device can be lowered to increase the service life of the device.

Preferably, the charging device further includes an opening/closing device configured to open and close the ventilation opening. The opening/closing device is configured to open the ventilation opening when the battery pack is mounted on the housing and configured to close the ventilation opening when the battery pack is detached from the housing.

The above configuration can prevent an air current from flowing into the ventilation opening when the battery pack is detached. Accordingly, the control board and the inside of the housing can be efficiently cooled. Specifically, the standby time in the sequential charging is reduced so that the charging time of battery packs can be shortened.

Preferably, the charging device further includes an opening/closing device configured to open and close the ventilation opening. The opening/closing device is configured to open the ventilation opening when a temperature inside the battery pack increases and configured to close the second ventilation opening when the temperature inside the battery pack decreases.

Preferably, the opening/closing device includes a bi-metallic strip.

According to the above configuration, the battery pack can be cooled in accordance with the temperature of the battery pack. Further, the control board and the inside of the housing can be selectively cooled when the temperature of the battery pack is low. Accordingly, the control board and the inside of the housing can be efficiently cooled. Specifically, the standby time in the sequential charging is reduced so that the charging time of battery packs can be shortened.

Preferably, the charging device further includes temperature detection means configured to detect a temperature inside the housing. A rotational speed of the cooling fan is controlled in accordance with the temperature inside the housing.

According to the above configuration, the battery pack can be cooled in accordance with the temperature inside the charging device. Further, the inside of the charging device can be cooled in accordance with the temperature inside the charging device, in the state where the battery pack is detached. Accordingly, the control device and the inside the housing can be cooled efficiently. Specifically, the standby time in the sequential charging is reduced so that the charging time of battery packs can be shortened.

Preferably, the charging device is further configured to stop the cooling fan from rotating when the temperature inside the housing is lower than or equal to a predetermined temperature.

According to the above configuration, the cooling fan is driven until the temperature inside the housing is lower than or equal to a predetermined temperature, and is stopped when the temperature becomes lower than or equal to a predetermined temperature. Therefore, the cooling can be efficiently carried out.

Preferably, the charging device further including a battery temperature detection means configured to detect a temperature inside the battery pack. A rotational speed of the cooling fan is controlled in accordance with the temperature inside the battery pack.

According to the above configuration, the rotational speed of the cooling fan can be increased and decreased in accordance with the temperature inside the battery pack. Accordingly, the cooling can be the cooling can be efficiently carried out.

Preferably, the charging device further including a display portion configured to display a state of one of the temperatures inside the housing and inside the battery pack.

According to the above configuration, a user can determine whether charging can be performed since the display portion indicates the state of the temperature.

### [Advantageous Effects of Invention]

As described above, the present invention can provide a charging device that can efficiently cool the internal components.

### [Brief Description of Drawings]

[Fig. 1]

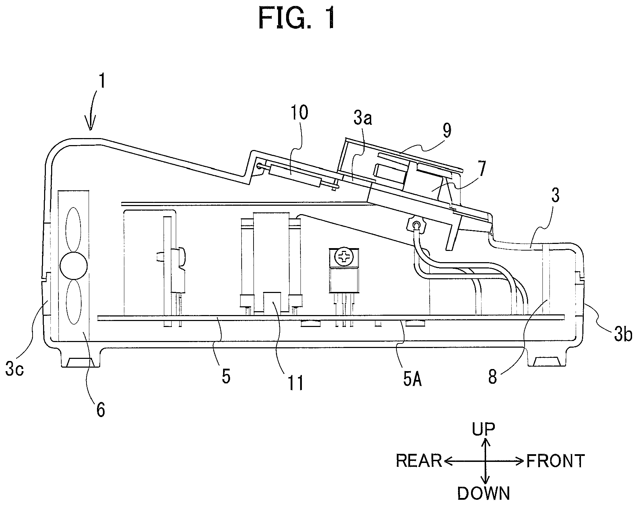

   Fig. 1 is a cross-sectional view of a charging device according to an embodiment of the present invention;
[Fig. 2]

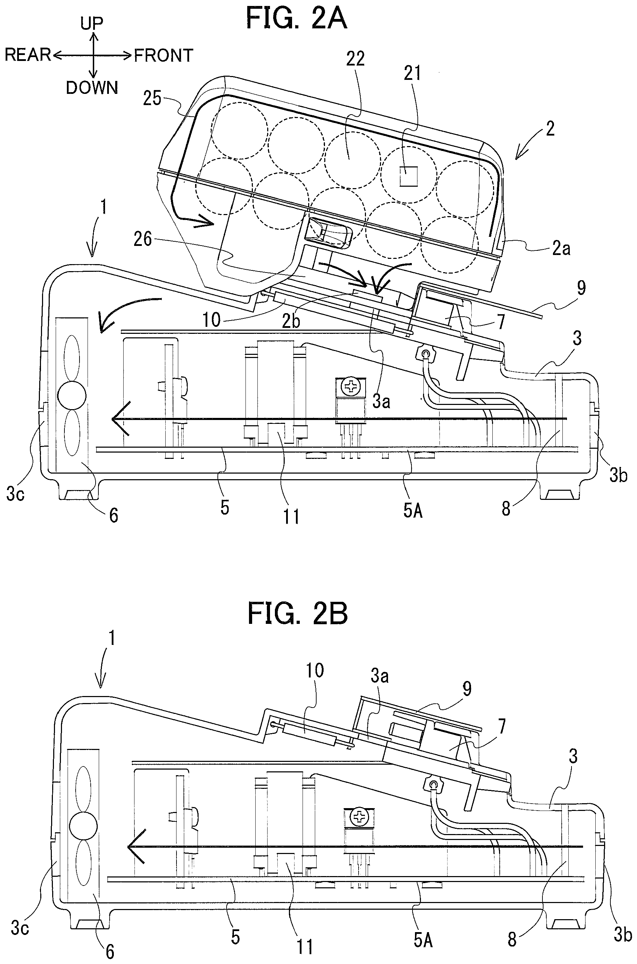

   Fig. 2A is a cross-sectional view of the charging device according to the embodiment of the present invention in a state where a battery pack chargeable by the charging device is mounted on the charging device; and
   Fig. 2B is a cross-sectional view of the charging device according to the embodiment of the present invention in a state where the battery pack is detached;
[Fig. 3]

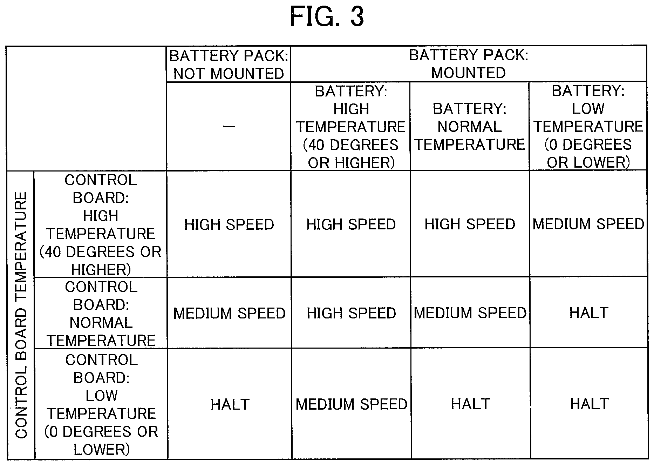

   Fig. 3 is a table illustrating a relation between a rotational speed of the cooling fan, a mounted/detached state of the battery pack, and a temperature of a control board in the charging device according to the embodiment of the present invention;
[Fig. 4]

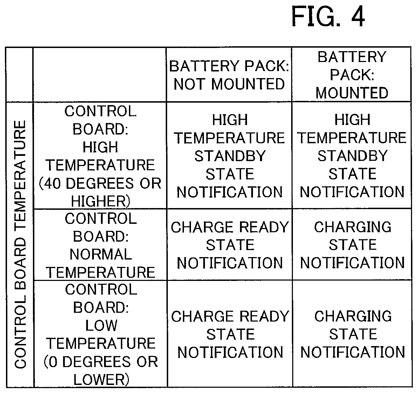

   Fig. 4 is a table illustrating a relation between indications of a LED display unit and the temperature of the control board in the charging device according to the embodiment of the present invention;
[Fig. 5]

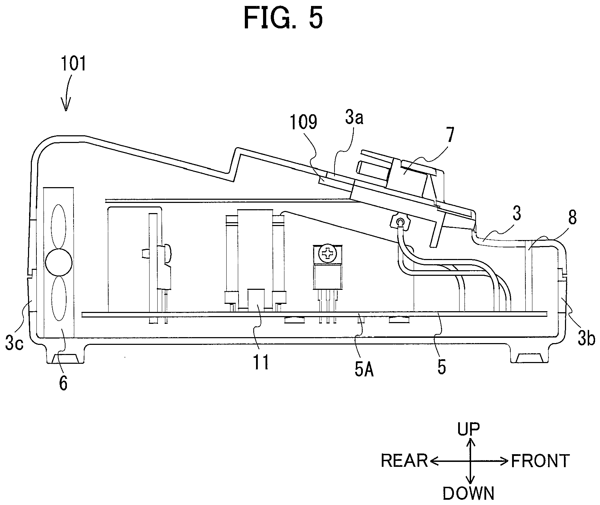

   Fig. 5 is a cross-sectional view of a charging device according to a modification of the present invention;
[Fig. 6]

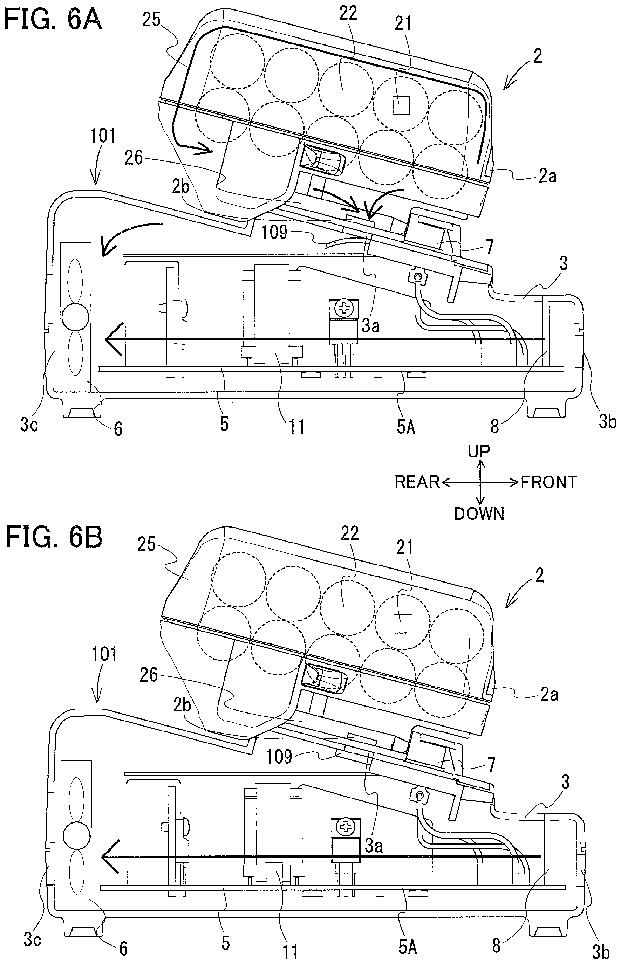

   Fig. 6A is a cross-sectional view of the charging device and a battery pack chargeable by the charging device according to a modification of the present invention, in a state where the inside of the battery pack has a high temperature; and
   Fig. 6B is the cross-sectional view of the charging device and the battery pack chargeable by the charging device according to the modification of the present invention, in a state where the inside of the battery pack is lower than the high temperature.

### [Description of Embodiments]

Next, a charging device 1 according to a preferred embodiment of the invention and a battery pack 2 that is charged by the charging device 1 will be described with reference to Figs. 1 through 4.

As shown in Figs. 1 and 2, the charging device 1 according to the preferred embodiment is a device that charges the battery pack 2. The device body of the charging device 1 is configured of a housing 3 formed of resin material possessing an electrical insulating property.

In the following description, the right-left direction in Fig. 1 will be defined as the front-rear direction relative to the charging device 1. Further, the vertical direction in Fig. 1 will be defined as the vertical direction relative to the charging device 1, and the direction orthogonal to the paper surface of Fig. 1 will be defined as the left-right direction relative to the charging device 1.

The battery pack 2 is shown in Fig. 2A. The battery pack 2 can be used in a power tool (not shown). The battery pack 2 is detachably mountable on the charging device 1. Specifically, the battery pack 2 is mounted on the charging device 1 by sliding the battery pack 2 over the top surface of the housing 3 in the approximate front-rear direction. The battery pack 2 has secondary battery cells 22 configured of lithium-ion cells; a protection IC (not shown) that monitors the occurrence of overcharge, overcurrent, and the like; a battery-side thermistor 21 that detects the temperature in the battery pack 2 and outputs signals to the protection IC indicating the detected temperature; a battery case 25 constituting the overall outer shell of the battery pack 2 and functioning to accommodate the battery cells 22; and a battery terminal unit 26 that forms an electrical connection with the charging device 1 when the battery pack 2 is mounted on the charging device 1, or with a power tool when the battery pack 2 is mounted on the power tool. Vent-holes 2a and 2b are formed in the battery case 25 for allowing cooling air to flow through the interior of the battery pack 2. In the preferred embodiment, cooling air is drawn into the battery pack 2 through the vent hole 2a and expelled from the battery pack 2 through the vent hole 2b.

The housing 3 internally accommodates a control board 5, a cooling fan 6, a thermistor 11, and an LED display unit 8. A top ventilation opening 3a is formed in the top surface of the housing 3. A front ventilation opening 3b is formed in the front surface of the housing 3. A rear ventilation opening 3c is formed in the rear surface of the housing 3. The top ventilation opening 3a is formed at a position for opposing the vent hole 2b when the battery pack 2 is mounted on the housing 3. A charger terminal unit 7 is disposed on the top surface of the housing 3 and is capable of connecting with the battery terminal unit 26 of the battery pack 2. A cover 9 is provided on the top surface of the housing 3 for covering the tops of the charger terminal unit 7 and top ventilation opening 3a.

The cooling fan 6 is electrically connected to the control board 5 and operates when power is supplied from the control board 5. The cooling fan 6 functions to circulate cooling air through the interiors of the housing 3 and battery case 25 for cooling the same.

The thermistor 11 detects the internal temperature of the housing 3 and outputs temperature information to the control board 5 in the form of electric signals. In the preferred embodiment, the thermistor 11 is disposed on top of the control board 5 to detect the temperature of components on the control board 5 that generate heat because the control board 5 is the primary source of heat among all components in the charging device 1.

The LED display unit 8 is electrically connected to the control board 5 and serves to display various information, including information on the internal temperature of the housing 3. For example, the LED display unit 8 employs LEDs to emit various colors of light and to blink lights in order to notify the user of the temperature condition of the control board 5 and the capability of the charging device 1 to charge the battery pack 2. For example, the LED display unit 8 may use such methods as flashing a red light when on standby due to a high temperature (hereinafter called a "high temperature standby state") or turning on a green light when the charging device 1 is ready to charge (hereinafter called a "charge ready state").

The cover 9 has a general rectangular shape in a side view. The cover 9 is provided with a spring 10. The lower rear edge of the cover 9 is connected to the top surface of the housing 3 via the spring 10. Specifically, the lower rear edge of the cover 9 is engaged by the front end of the spring 10, and the rear end of the spring 10 is engaged in the interior of the housing 3. The spring 10 urges the cover 9 rearward. The cover 9 and spring 10 correspond to the opening/closing device of the invention.

While the battery pack 2 is not mounted on the housing 3, the urging force of the spring 10 places the cover 9 in a position for covering and closing the top ventilation opening 3a from above (see Fig. 2B).

When the battery pack 2 is mounted on the housing 3, the battery pack 2 presses against the rear surface of the cover 9, causing the cover 9 to slide over the top surface of the housing 3 against the urging force of the spring 10. The cover 9 moves to a position that opens the top ventilation opening 3a (see Fig. 2A). At this time, the battery terminal unit 26 and charger terminal unit 7 are in contact with each other and form an electrical connection. Further, the top ventilation opening 3a confronts the vent hole 2b, forming a passage for cooling air to travel from the interior of the battery case 25 into the interior of the housing 3.

The control board 5 is disposed in the bottom section of the housing 3 and is electrically connected to the charger terminal unit 7. The control board 5 is electrically connected to the battery pack 2 through the charger terminal unit 7 and the battery terminal unit 26. The control board 5 also includes a control circuit 5A for controlling the components of the charging device 1.

The control circuit 5A functions to control the LED display unit 8. The control circuit 5A also controls the operations of the cooling fan 6 based on temperature information detected by the thermistors 11 and 21 in order to control the temperatures of the charging device 1 and battery pack 2. The control operation of the cooling fan 6 will be described later in greater detail. The control circuit 5A also receives signals via the protection IC of the battery pack 2 related to temperature, battery type, and the occurrence of overcharge and overcurrent and controls the charging current based on these signals.

The control circuit 5A controls the rotating speed of the cooling fan 6 based on the temperature of the control board 5 detected by the thermistor 11, the presence of a mounted battery pack 2, and the temperature information for the battery pack 2. Fig. 3 is a table provided to describe control of the cooling fan 6. In Fig. 3, the temperature conditions of the control board 5 are indicated in the first column, and the mounting conditions and temperature conditions of the battery pack 2 are indicated in the first rows. The control circuit 5A sets the rotational speed of the cooling fan 6 as shown in Fig. 3 according to each of these conditions.

That is, when the battery pack 2 is at a high temperature, the control circuit 5A increases the rotational speed of the cooling fan 6 in order to cool the battery pack 2 quickly. The control circuit 5A also increases the rotational speed of the cooling fan 6 when the control board 5 is at a high temperature in order to cool the control board 5 rapidly. A particular feature of the invention is that the operation and speed of the cooling fan 6 is controlled based on the temperature of the control board 5 even when a battery pack 2 is not mounted on the housing 3. When the temperature of the control board 5 is high and the control board 5 must be cooled rapidly, the control circuit 5A rotates the cooling fan 6 at a high speed. The control circuit 5A rotates the cooling fan 6 at a medium speed if the control board 5 must be cooled but has not yet reached a high temperature. When cooling is unnecessary, the control circuit 5A halts rotation of the cooling fan 6. Note that the control circuit 5A is not limited to the method of rotating the cooling fan 6 at a medium speed when the control board 5 is at a normal temperature, but may rotate the cooling fan 6 at a low speed instead. Alternatively, the control circuit 5A may rotate the cooling fan 6 at a low speed or halt the cooling fan 6 for temperatures between 1 and 29°C (degrees centigrade) and may rotate the cooling fan 6 at a medium speed for temperatures between 30 and 39°C.

Fig. 4 shows correspondences between indications given by the LED display unit 8 and the temperatures of the control board 5. The indications of the LED display unit 8 vary in accordance with the temperature condition of the control board 5. For example, when the control board 5 is at a high temperature (40°C or higher in the preferred embodiment), the charging device 1 is in a high temperature standby state. In this state, the control board 5 is prevented from charging in order to protect the components of the charging device 1. Here, the LED display unit 8 indicates the high temperature standby state by flashing a red light, for example, thereby informing the user of the internal condition of the charging device 1. If the battery pack 2 is not mounted on the housing 3 and the control board 5 is at a normal temperature (greater than 0°C and less than 40°C) or a low temperature (less than or equal to 0°C), the LED display unit 8 indicates a charge ready state by turning on a green light, for example. When the battery pack 2 is mounted on the housing 3 and the control board 5 is at a normal temperature or a low temperature, the LED display unit 8 indicates that charging is in progress by turning on an orange light, for example. By viewing these indications, the user can understand the current state of the charging device 1.

Next, the cooling operations performed by the control board 5 will be described. Cooling air circulates in the charging device 1 and battery pack 2 as indicated by arrows in Figs. 2A and 2B. When the cooling fan 6 is operated while the battery pack 2 is mounted on the housing 3, as illustrated in Fig. 2A, cooling air flows into the battery case 25 through the vent hole 2a and flows into the housing 3 through the vent hole 2b and top ventilation opening 3a. When passing through the battery case 25, the cooling air flows around the internal components of the battery case 25, such as the battery cells 22, thereby cooling these components. Subsequently, the cooling air passes through the cooling fan 6 and is exhausted from the charging device 1 through the rear ventilation opening 3c.

A separate circulation path for cooling air is formed in the housing 3. As shown in Fig. 2A, a path for cooling air is formed from the front ventilation opening 3b to the rear ventilation opening 3c when the cooling fan 6 is operated. While passing through the interior of the housing 3, the cooling air cools the internal components of the housing 3, including the control board 5, and is exhausted from the charging device 1 through the rear ventilation opening 3c.

When the battery pack 2 is removed from the housing 3, the cover 9 closes the top ventilation opening 3a, as shown in Fig. 2B. At this time, the path from the front ventilation opening 3b to the rear ventilation opening 3c for cooling air passing through the interior of the housing 3 is still open. Thus, the control board 5 operates the cooling fan 6 based on the temperature detected by the thermistor 11, even when the battery pack 2 has been removed from the housing 3, in order to cool the control board 5 and the interior of the housing 3.

As described above, the charging device 1 according to the present invention can cool both the battery pack 2, and the interior of the housing 3, including the control board 5. Thus, the charging device 1 is capable of rapidly cooling not just the battery pack 2 but also the control board 5 and the interior of the housing 3. Further, since the control board 5 is cooled even when the battery pack 2 is not mounted on the housing 3, the charging device 1 can efficiently cool the control board 5 after a charging operation. This capability is particularly advantageous for charging a plurality of battery packs 2 one after another (i.e., sequential charging) by shortening the time spent cooling the internal components of the charging device 1 in a high temperature standby state (the standby time) and, hence, shortening the overall charging time for the battery packs 2. Further, by reducing the temperature of components inside the charging device 1, the present invention can increase the service life of the device.

Since the cover 9 opens and closes the top ventilation opening 3a depending on whether the battery pack 2 is mounted on the housing 3, the cover 9 can prevent cooling air from flowing in and out through the top ventilation opening 3a while the battery pack 2 is not mounted on the housing 3. Accordingly, this structure can modify the pathways of cooling air depending on the mounted state of the battery pack 2. Hence, the charging device 1 can efficiently cool the control board 5 and the interior of the housing 3 and can reduce the standby time during sequential charging. Further, since the cover 9 closes the top ventilation opening 3a when the battery pack 2 is not mounted on the housing 3, the cover 9 can prevent dust and the like above the housing 3 from entering the housing 3 through the top ventilation opening 3a.

In the preferred embodiment, the control board 5 controls the cooling fan 6 based on the temperature detected by the thermistor 11. Hence, the control board 5 can cool the battery pack 2 in accordance with the internal temperature of the charging device 1. The control board 5 can also control cooling based on the temperature of the control board 5 (the interior of the housing 3) even when the battery pack 2 is not mounted on the housing 3. In this way, the control board 5 can reduce the standby time during sequential charging.

In the preferred embodiment, the control board 5 also operates the cooling fan 6 while the temperature of the control board 5 remains above a prescribed temperature, and only halts the cooling fan 6 when the temperature falls to or below the prescribed temperature, as indicated in Fig. 3. Hence, the charging device 1 can cool the control board 5 efficiently by reducing power required for cooling. Further, since the control board 5 adjusts the rotational speed of the cooling fan 6 according to the internal temperature of the battery pack 2, the charging device 1 can cool the battery pack 2 efficiently.

While the invention has been described in detail with reference to specific embodiments thereof, it would be apparent to those skilled in the art that many modifications and variations may be made therein without departing from the spirit of the invention, the scope of which is defined by the attached claims.

In the preferred embodiment, the cooling fan 6 guides cooling air by drawing the air in through the front ventilation opening 3b and top ventilation opening 3a and expelling the air out through the rear ventilation opening 3c, but the present invention is not limited to this arrangement. For example, the cooling fan 6 may be operated in reverse of the embodiment so as to draw cooling air in through the rear ventilation opening 3c and to expel the air out through the front ventilation opening 3b and top ventilation opening 3a. This variation can obtain the same effects described in the embodiment. The cooling fan 6 also need not be an axial-flow fan, as in the embodiment, but may be a different type of fan, such as a sirocco fan (centrifugal fan).

The cover 9 and spring 10 configuring the opening/closing device in the preferred embodiment function to open and close the top ventilation opening 3a when the battery pack 2 is mounted and removed. However, the present invention is not limited to this arrangement. For example, a structure constituting an opening/closing device used in place of the cover 9 and spring 10 that is capable of opening and closing the top ventilation opening 3a based on the internal temperature of the battery pack 2 falls within the scope of the invention.

### Variations of the Embodiment

Next, a charging device 101 according to a variation of the embodiment will be described with reference to Figs. 5, 6A and 6B. While the cover 9 and 10 are used as an example of the opening/closing device in the embodiment, a cover 109 is used in place of the cover 9 and spring 10 in this variation. Note that components other than the cover 109 in this variation are identical to those in the embodiment, and like parts and components are designated with the same reference numerals to avoid duplicating description.

The cover 109 is a plate-shaped member made from a bi-metallic strip. The front edge of the cover 109 is fixed to the housing 3. The cover 109 is provided so as to cover and close the top ventilation opening 3a from below at normal and low temperatures (see Fig. 5). More specifically, the cover 109 is configured by bonding together two types of plate-shaped metals having different coefficients of linear expansion. The metal material used as the top layer of the cover 109 has a relatively large coefficient of linear expansion, while the metal material used as the bottom layer of the cover 109 has a small coefficient of linear expansion.

When the battery pack 2 is mounted on the housing 3, the cover 109 is exposed to the air inside the battery pack 2 via the vent hole 2b. When a battery pack 2 is not mounted on the housing 3 or when the internal temperature of the battery pack 2 is a normal or low temperature, the cover 109 continues to close the top ventilation opening 3a (see Figs. 5 and 6B).

When the internal temperature of the battery pack 2 reaches a high temperature, the cover 109 exposed to the hot air in the battery pack 2 deforms by bending downward, as illustrated in Fig. 6A. That is, the cover 109 bends downward because the plate having the relatively large coefficient of linear expansion constituting the top layer expands more than the plate constituting the bottom layer. As the cover 109 bends downward, the top ventilation opening 3a is opened. When the top ventilation opening 3a is opened, the interior of the battery pack 2 is in communication with the interior of the housing 3 through the vent hole 2b and top ventilation opening 3a. This communication established between the interior of the battery pack 2 and the interior of the housing 3 forms a passage for cooling air to flow from the battery pack 2 into the housing 3.

The structure in the variation can implement an opening/closing device for opening and closing the top ventilation opening 3a according to the internal temperature of the battery pack 2. This structure can limit the cooling air pathways to only the path formed in the housing 3 when a battery pack 2 is not mounted on the housing 3 or when the internal temperature of the battery pack 2 is normal or low, thereby focusing cooling on the control board 5 and the interior of the housing 3. When the internal temperature of the battery pack 2 is at a high temperature, this structure allows cooling air to flow into the battery pack 2, thereby cooling the battery pack 2 as well as the control board 5 and the interior of the housing 3.

Thus, the structure of the variation can provide a charging device 101 capable of efficiently cooling parts and components having a high temperature based on the presence of a mounted battery pack 2 and the internal temperature of the same.

As another variation, an opening/closing device combining a member capable of covering the top ventilation opening 3a and a motor for moving this member may be provided in place of the cover 9 or 109. In this case, the control board 5 controls the opening/closing device to open and close the top ventilation opening 3a based on the temperatures detected by the thermistors 11 and 21. The structure of this variation can also achieve a charging device 1 capable of efficiently cooling parts and components having a high temperature based on the presence of a mounted battery pack 2 and the internal temperature of the same.

The preferred embodiment and variations thereof have presented charging devices 1 and 101 capable of mounting a single battery pack 2, but the present invention is not limited to this arrangement. The present invention may also be applied to a charging device 1 capable of mounting a plurality of battery packs 2 simultaneously by providing pluralities of the top ventilating holes 3a, opening/closing devices, charger terminal units 7, and the like on the housing 3. By configuring the opening/closing devices to close only those corresponding ventilation openings over which battery packs 2 are mounted, the charging device 1 can obtain the same effects as the preferred embodiment. Alternatively, by using the opening/closing devices to open ventilation openings only for battery packs 2 that are mounted and that have a high internal temperature, the charging device 1 can obtain the same effects as the variation of the embodiment.

While the thermistor 11 is disposed on the control board 5 in the embodiment and variations thereof, the present invention is not limited to this configuration. The thermistor 11 may be disposed near other components in order to detect the internal temperature of the housing 3.

In the embodiment and variations thereof, the threshold values defining high, normal, and low temperatures are 40°C and 0°C. However, the present invention is not limited to these threshold values. Definitions of a high temperature, normal temperature, and low temperature may be adjusted as needed according to the properties of the components constituting the battery pack and charging device.

In the embodiment and variations thereof, the LED display unit 8 is configured to indicate a high temperature standby state, charge ready state, and the like as the internal temperature condition of the housing 3, but the present invention is not limited to this arrangement. For example, a liquid crystal display unit may be provided in the charging device 1 for displaying the temperature values themselves.

While the battery cells 22 are lithium-ion batteries in the embodiment and variations thereof, the present invention is not limited to these battery cells. The cells of the present invention may include lithium-ion battery cells, nickel-metal hydride battery cells, lithium-ion polymer battery cells, nickel-cadmium battery cells, and the like.

### [Reference Signs List]

1...charging device, 2...battery pack, 3...housing, 5...control board, 6...cooling fan, 7... charger terminal units, 8... display unit, 9... cover, 10... spring, 11... thermistor

## Claims

1. A charging device comprising:
a housing on which a battery pack is detachably mountable; and
a cooling fan disposed in the housing and configured to generate cooling air in the housing even in a state where the battery pack is detached from the housing.

2. The charging device according to claim 1, wherein the battery pack has a vent hole;
wherein the housing accommodates therein a control board and is formed with a ventilation opening, the control board being configured to control charging of the battery pack, the ventilation opening being configured to face the vent hole when the battery pack is mounted on the housing; and
wherein at least one of the battery pack and the control board is configured to be cooled by the cooling air generated by the cooling fan.

3. The charging device according to claim 2, further comprising an opening/closing device configured to open and close the ventilation opening, the opening/closing device being configured to open the ventilation opening when the battery pack is mounted on the housing and configured to close the ventilation opening when the battery pack is detached from the housing.

4. The charging device according to claim 2, further comprising an opening/closing device configured to open and close the ventilation opening, the opening/closing device being configured to open the ventilation opening when a temperature inside the battery pack increases and configured to close the second ventilation opening when the temperature inside the battery pack decreases.

5. The charging device according to claim 4, wherein the opening/closing device comprises a bi-metallic strip.

6. The charging device according to any one of claims 1 through 5, further comprising a temperature detection means configured to detect a temperature inside the housing, a rotational speed of the cooling fan being controlled in accordance with the temperature inside the housing.

7. The charging device according to claim 6, further configured to stop the cooling fan from rotating when the temperature inside the housing is lower than or equal to a predetermined temperature.

8. The charging device according to any one of claims 1 through 7, further comprising a battery temperature detection means configured to detect a temperature inside the battery pack, a rotational speed of the cooling fan being controlled in accordance with the temperature inside the battery pack.

9. The charging device according to any one of claims 6 through 8, further comprising a display portion configured to display a state of one of the temperatures inside the housing and inside the battery pack.

10. A charging device comprising:
a housing on which a battery pack is detachably mountable, the housing accommodating therein a control board configured to control charging of the battery pack; and
a cooling fan disposed in the housing and configured to be driven by the control board;
wherein the cooling fan is configured to be driven by the control board even in a state where the battery pack is detached from the housing.
